(19) Europäisches Patentamt / European Patent Office / Office européen des brevets

(11) **EP 2 819 412 A1**

(12) **EUROPEAN PATENT APPLICATION**

(43) Date of publication:
31.12.2014 Bulletin 2015/01

(51) Int Cl.:
*H04N 19/146* (2014.01)     *H04N 19/17* (2014.01)
*H04N 19/124* (2014.01)     *H04N 19/593* (2014.01)

(21) Application number: 13170946.1

(22) Date of filing: 06.06.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: **Fujitsu Semiconductor Limited**
**Kohoku-ku, Yokohama-shi**
**Kanagawa 222-0033 (JP)**

(72) Inventor: **Richter, Roland**
**81476 Munich (DE)**

(74) Representative: **Lewin, David Nicholas**
**Haseltine Lake LLP**
**Lincoln House, 5th Floor**
**300 High Holborn**
**London WC1V 7JH (GB)**

Remarks:
Amended claims in accordance with Rule 137(2)
EPC.

(54) **Encoding and decoding**

(57)     There is disclosed a method of encoding Q-bit input data values, where Q is an integer greater than 1, the method comprising: outputting an encoded data value for each of said input data values, where each encoded data value represents an offset to the corresponding input data value from a bias value closer to that input value than the value zero and is expressed as an R-bit value, where R is an integer greater than or equal to 1 and less than Q. A complementary decoding method is also disclosed.

FIGURE 4

**Description**

The present invention relates to encoding and decoding methods, apparatuses and programs.

In particular, the present invention relates to a technique for encoding data values such that the resultant data is in a compressed form. Such data values may for example be a series or sequence of data values expressed in a particular bit format. Streamed image data, where each data value in the stream represents the value of a pixel in an image, is one example of data values to which the invention may be applied. The invention also provides a technique for decoding such resultant data to provide data values in a decompressed form. Both lossless and lossy compression is considered.

By way of background, most previously-considered techniques for lossless image compression are based on eliminating redundancies and on Huffman Encoding for bit reduction (e.g., PNG compression). Such techniques require significant arithmetic effort for finding and sorting algorithms.

Previously-considered lossy image compression techniques typically perform bit reduction by quantization in a Fourier representation of image data (e.g. JPEG), i.e. with some analysis in the frequency domain. This can achieve high compression rates at low visibility of artefacts (undesired alterations in the data introduced during the compression, usually perceived as a loss of clarity), however it requires immense arithmetic effort for transformations and other operations.

In both cases, encoding is typically block-based and the techniques when implemented in hardware consequently require a significant amount of line buffer memory for both the decoder and encoder hardware apparatus.

Run-length encoding (RLE) is a well-known and simple form of data compression in which runs of data (sequences or streams in which the same data value occurs in many consecutive data elements or values) are stored as a single data value and count, rather than as the original run. This is most useful on data that contains many such runs. This may be the case, for example, with simple graphic images such as icons, line drawings and animations. The technique is not so useful with files that do not have many such runs as it could greatly increase the file size.

For example, a screen may contain plain black text on a solid white background. On such a screen there may be many long runs of white pixels in the blank space, and short runs of black pixels within the text. A hypothetical single scan line may be as follows, with B representing a black pixel and W representing a white pixel:

WWWWWWWWWWWWWWWBBBWWWWWWWWWWWWBBBWWWWWWWWWWWWWWW

If run-length encoding (RLE) is applied to the above hypothetical scan line the following encoding data may be produced:

15W3B12W3B15W

This is to be interpreted as 15 W's, 3 B's, 12 W's, 3 B's, and 15 W's, and each RLE unit (e.g., "15W" or "3B") may be referred to as a packet or package. The run-length code in this example represents the original 48 characters in only 13 characters, and as such the original characters have been compressed. Of course, the actual format used for the storage of images is generally binary rather than ASCII characters as above, but the general principle remains the same.

Run-length encoding performs lossless data compression and is well suited to palettebased iconic images. It does not work well however on continuous-tone images such as photographs or video.

It is desirable to solve one or more of the above problems.

It is desirable to provide a compression format along with algorithms for decoding and encoding which can be implemented in hardware with minimal complexity and which have good arithmetic re-use. It is desirable to provide lossy image compression of dynamic content with a fixed compression rate, for example to enable predictable memory and bandwidth saving for video-like signals. It is also desirable to provide lossless image compression of static content with an undefined compression rate (for example to enable memory saving for pre-rendered images).

It is further desirable to provide decoder and encoder algorithms/methods which are suitable for implementation in hardware, and which are able to operate on a series of data values (e.g., a pixel stream) such that no buffer such as a frame buffer is needed. Any such technique preferably should require no line buffers to keep impact on design size small, and have low arithmetic complexity for similar reasons. Where the data is image data, the technique is preferably flexible in colour formats that are compressed (e.g., as regards number and bit size of channels).

It is still further desirable to provide decoding and encoding techniques and algorithms that may be simple enough to be implemented in hardware at multiple points in a design directly where data (e.g., image data) is written to memory (e.g., video capture streams, or destination buffers for blit operations) or read from memory (e.g., display buffers, or source buffers for blit operations) while keeping impact on design cost moderate.

According to a first aspect of the present invention there is provided a method of encoding Q-bit input data values, where Q is an integer greater than 1, the method comprising: outputting an encoded data value for each of said input data values, where each encoded data value represents an offset to the corresponding input data value from a bias value closer to that input value than the value zero and is expressed as an R-bit value, where R is an integer greater than or equal to 1 and less than Q.

By virtue of such a method, the input data values may be output in compressed form, by way of said encoded data values. Moreover, such a method has been found to be conveniently elegant such that it may be implemented in low-complexity hardware (which, for example, does not take up much space or consume much power, and which may be operated at high speed). For example, wired logic circuitry may be employed. The method may also be implemented in software.

The Q-bit input data values could be received in a stream and encoded on-the-fly, e.g. one-by-one or plurality-by-plurality, as they are received. The input data values could also be accessed from storage and then encoded, for example with the encoding method able to look forward and backward in a series of such data values.

The input data values could be image data values, or audio data values, or represent some other characteristic or property (e.g. pressure, temperature, volume, length, weight, speed).

The value Q may be the same for each input data value, or may vary per input data value or group/plurality of input data values. Similarly, the value R may be the same for each encoded data value, or may vary per encoded data value or group/plurality of input data values.

Each offset may be a difference between the input data value concerned and its respective bias value. Each encoded data value may represent its offset in that it is the same as or based upon (e.g. by some factor) that offset value. The bias value for a particular input data value (or for some or all data values) may be sufficiently closer to that input value than zero such that R is (significantly) less than Q. Although R may be one less than Q, it is preferably two or more less than Q.

The bias value for a particular input data value (or for some or all data values) may be dynamically set. That is, the bias value for a particular input data value may be dependent on that input data value, or on a plurality/group of input data values including that input data value. Such a bias value may be the same as one of those input data values.

The method may comprise, for a group of said input data values, selecting a group bias value, and outputting such an encoded data value per input data value where each encoded data value represents an offset to the corresponding input data value from the group bias value or from another bias value obtainable by combining the group bias value and one or more of the encoded data values.

Where said input data values and their encoded data values are organised into an order (e.g. the input data values may be received, and their encoded data values output, in the order), a particular encoded data value may represent an offset to the corresponding input data value from the group bias value or from another bias value obtainable by combining the group bias value and one or more of the encoded data values earlier in said order.

Such combination may comprise one or more of addition, subtraction, multiplication and division.

The method may comprise, for such a group of input data values, selecting a group bias value common to those input values, and outputting such an encoded data value per input data value where each encoded data value represents an offset to the corresponding input data value from the group bias value.

The method may comprise, for such a group of said input data values, the input data values of the group being organised into an order, selecting a group bias value, and outputting an encoded data value per input data value, wherein: the encoded data value for the first input data value in said order represents an offset to that input data value from the group bias value; and the encoded data value for each subsequent input data value in said order represents an offset to that input data value from its own bias value being equal to the preceding input data value in the order or equal to the sum of the offset value and the bias value for the preceding input data value in said order. That is, the encoded data values may represent (e.g. be the same as) the differences between consecutive input data values.

The order may be an order in which the input data values are received or accessed or arranged/organised. For example, in the case of image data, the input data values may be pixel values and the order may correspond to an order in which the pixels are arranged in an image.

The method may comprise, for such a group of input data values, selecting the group bias value to be equal to the smallest input data value of the group, or equal to another input data value of the group, or equal to a value dependent on some or all of the input data values of the group.

The number of input data values in such a group may be considered a count value. For a group of input data values, the method may comprise outputting the encoded data values with the count value and the group bias value. The encoded data values, the count value and the group bias value may be output together, e.g. as a packet (or package) of values. The packet may comprise a header portion, e.g. having the count and group bias values, and a payload portion, e.g. having the encoded data values.

Q may be the same for each input data value of the group and/or R may be the same for each encoded data value of the group. The value of Q and/or R may be output with the encoded data values, e.g. as part of such a header portion.

R may be equal to or less than a value Z being the minimum value or another value (just) sufficient to express the offsets for said group without loss. For reasons of compression, Z may be less than Q.

The method may comprise also encoding some input data values such that R is equal to or greater than Q, but such that overall the encoded data values represent the input data values in compressed form. Thus, R need not be less than Q for all groups.

The method may comprise controlling the number of input data values in the group so that Z is below a given limit. Thus, the number of input data values in the group may be different from group-to-group, although it may also be the same from group-to-group. For example, the number of input data values in the group (i.e. the count value) may be controlled dynamically, dependent on the values of the input data values. The method may comprise controlling the number of input data values in the group so that Z is below a given limit on average over a number of said groups, or so that Z is below a given limit for each group individually.

When R is less than Z, the encoded data values may be expressed as R-bit values by quantization with respect to corresponding Z-bit values. That is, Z-bit encoded data values in the Z-bit space (i.e. from the set of values expressible by Z bits) may be converted to R-bit values in the R-bit space (i.e. from the set of values expressible by R bits) by quantization. Where a particular Z-bit value corresponds to a value between two R-bit values, the method may comprise selecting and outputting one of those R-bit values as the encoded data value based on particular rules.

For example, the rules might dictate that the higher, lower or closer of the two R-bit values is selected. The rules might dictate that dithering is employed to decide which R-bit value to output as the encoded data value. That is, when R is less than Z, the encoded data values may be expressed as R-bit values by quantization with dithering.

The dithering may be spatial or temporal dithering. The dithering may be based on a dither matrix.

When R is less than Z and quantization is performed, the method may comprise outputting with the encoded data values of a group a configuration value indicating that the encoded data values were generated by quantization. Such a configuration value may be included in the header portion of such a group, and be useful for decoding the encoded data values. The configuration value may indicate the extent of the quantization, e.g. the difference between Z and R.

The method may comprises setting R to be equal to Z when setting R to be equal to Z at least meets a performance target, and setting R to be less than Z when setting R to be less than Z would meet the performance target but setting R to be equal to Z would not meet the performance target.

The performance target may be or comprise a compression-rate target, relating to the degree of compression achieved by the encoding method relative to the input data values. The performance target may be or comprise a data-rate target, relating to the rate in which values or bits (e.g. bit rate) are output by the encoding method.

The method may comprise outputting encoded data values for a series of said groups, and setting R to be equal to or less than Z on a group-by-group, or input data value-by-input data value, basis. The series of groups may be consecutive groups in an ordered set of groups, or may be a sub-set of those groups, not necessarily consecutive. For example, one or more of the full set of groups may comprise data values which are encoded in a different way. For example, one or more such groups may comprise a pattern of input data values (e.g. identical input data values) which may be encoded in a different manner (e.g. by run-length encoding).

Given a performance target to be met on average over (preferably, at least) the series of groups, the method may comprise setting the value of R to be equal to or less than Z dynamically on a group-by-group basis in order to meet the performance target on average over the series of groups and preferably to suppress loss by quantization. That is, the method may have an aim of setting R to be as close as possible to, and preferably the same as, Z whilst also meeting or exceeding the performance target.

The method may comprise tending to set (or being biased or inclined to set) R to be equal to Z when the running performance would thereby meet or exceed the performance target, and tending to set (or being biased or inclined to set) R to be less than Z when the running performance would otherwise fail to meet the performance target.

The method may comprise maintaining (keeping, controlling, updating) a credit count whilst encoding the series of groups, the credit count being indicative of whether or not the running performance meets the performance target. The method may comprise, on a group-by-group basis, setting R to be equal to or less than Z in dependence upon the credit count.

An example method comprises, on a group-by-group basis, (one or more of):

- setting R to be equal to Z for groups of the series when this would cause the running performance to exceed the performance target, and incrementing a credit count in respect of those groups, the credit count being common to the series of groups;
- setting R to be equal to Z for groups of the series when this would cause the running performance to meet the performance target, and maintaining the credit count in respect of those groups;
- setting R to be equal to Z for groups of the series when the credit count indicates accumulated credit or accumulated credit above a threshold limit even when this would have a negative effect on the running performance, and decrementing the credit count in respect of those groups; and

- setting R to be sufficiently less than Z to have a positive effect on the running performance when setting R to be higher would have a negative effect on the running performance and the current credit count indicates no accumulated credit or accumulated credit below a threshold limit.

The input data values may be received as a stream of input data values, and encoded on-the-fly, one-by-one or group-by-group. The input data values may be image data values, wherein the encoded data values are compressed image data values.

According to a second aspect of the present invention there is provided a method of decoding encoded data values, where each encoded data value represents an offset to a corresponding target data value from a bias value (other than zero, e.g. greater than zero), the method comprising combining each encoded data value with its bias value to obtain the corresponding target data value.

When a said encoded data value is an R-bit value obtained by quantization with respect to a Z-bit value, where Z is greater and R, the combining may comprise converting the R-bit encoded data value to its corresponding Z-bit value in the Z-bit space and then combining the Z-bit encoded data value with its bias value to obtain the corresponding target data value.

The encoded data values may be received in groups corresponding to groups of input data values based on which the encoded data values were generated. The groups of encoded data values may be received with count and group bias values, e.g. as packets. Such packets may also comprise a configuration value indicating that the encoded data values were obtained by quantization, and optionally the degree of quantization.

Such packets may also comprise a configuration value indicating whether the group bias value is the bias value for each of the encoded data values of the group, or only for e.g. the first encoded data value of the group (the bias value for each subsequent encoded data value in the group - where they have an order - being e.g. the target data value corresponding to its preceding encoded data value).

According to a third aspect of the present invention there is provided a computer program which, when executed on a processor, causes the processor to carry out a method according to the aforementioned first or second aspect.

According to a fourth aspect of the present invention there is provided an encoder for encoding Q-bit input data values, where Q is an integer greater than 1, the encoder being operable to output an encoded data value for each of said input data values, where each encoded data value represents an offset to the corresponding input data value from a bias value closer to that input value than the value zero and is expressed as an R-bit value, where R is an integer greater than or equal to 1 and less than Q.

According to a fifth aspect of the present invention there is provided a decoder for decoding encoded data values, where each encoded data value represents an offset to a corresponding target data value from a bias value, the decoder being operable to combine each encoded data value with its bias value to obtain the corresponding target data value.

According to a sixth aspect of the present invention there is provided a method of encoding a series of input data values in order to meet a performance target on average over the series, the method comprising: outputting an encoded data value for each of said input data values, where each encoded data value is expressed as an R-bit value; and setting the value of R dynamically in order to meet the performance target. Corresponding computer program and encoder aspects are envisaged.

The value R may be set in accordance with the aforementioned first aspect of the present invention. The input data values and encoded data values may be encoded in accordance with the aforementioned first aspect of the present invention.

For example, it may be preferable to set R generally low to provide compression but to set R generally high to resist loss for example by way of quantization. It may be preferable to set R as high as possible whilst still meeting the performance target, which target may be related to compression rate or data rate.

It is envisaged that encoding (encoder) and decoding (decoder) aspects may be provided in combination.

The present invention extends to image-handling apparatus, comprising an encoder according to one or both of the aforementioned encoder aspects and/or to a decoder according to the aforementioned decoder aspect, wherein said data values are image data values. The present invention extends to image-handling apparatus, configured to carry out a method according one or more of the aforementioned method aspects. Such image-handling apparatus may comprise a computer program according to one or both of the aforementioned computer-program aspects.

Reference will now be made, by way of example, to the accompanying drawings, of which:

Figures 1(a) and 1(b) are schematic diagrams of an encoder and a decoder;
Figure 2 is a schematic diagram of an encoder/decoder as implemented in hardware;
Figure 3 is a schematic diagram of a system, representing an example application of the encoder and decoder of Figure 1;
Figure 4 is a schematic diagram showing how an example stream or series of input data values may be encoded;

Figure 5 is a schematic diagram presenting various different packets which each encode the input data values in Figure 4;

Figure 6A is a schematic diagram indicating that both lossless and lossy encoding (compression) may be performed;

Figure 6B is a schematic diagram provided to demonstrate the loss suffered based on the right-hand packet in Figure 6A;

Figure 7 presents an example flow in which "lossless" encoding is employed;

Figure 8 presents an example flow in which encoding having a controlled data rate or compression rate is desired;

Figure 9 presents an example flow in which encoding which would achieve a particular compression rate or better is desired; and

Figure 10 presents an example flow in which encoding that achieves at least a target average compression rate over time is desired.

By way of introduction, and taking streamed image data as an example (where the stream comprises pixel values), there are disclosed herein techniques and algorithms which perform bit reduction by storing either increments between adjacent pixels or additive offsets to a common bias value only per pixel. Groups of consecutive pixel values are "processed" together, to produce a packet which stores for example the bias value and increments/offsets. The number of pixels per packet is dynamic within a variable range (cf. run-length encoding). Each packet has a header word, for example including the bias value and a count value (representing the number of pixels expressed by the packet), and a payload portion containing the increments/offsets.

In case a fixed maximum is required for compression rate, additional bit reduction can be done by quantization with spatial dithering (or similar) of the offset values. Spatial dithering is preferred, because dither patterns are most visible on uniform colour distributions. These, however, can be compressed lossless in most cases by the present techniques. Thus, dithering is mostly desired on areas with higher frequencies and amplitudes only, where its visibility is significantly lower. Also, even though the disclosed techniques are line-based rather than block-based, by spatial dithering a vertical correlation of lossy image data is achieved (cf. y-coordinate of Bayer matrix).

Where data is image data, which comprises separate colour channels, each colour channel is preferably processed individually. This allows compression between channels to be balanced according to the contribution to luminance. It also accounts for stronger correlation of adjacent pixel data within a single channel and is more flexible to completely different colour formats.

The disclosed techniques may be implemented with a small pixel FIFO (First-In-First-Out) buffer only, which is independent in size from the supported frame dimensions, along with an amount of integer arithmetic for analysis of incoming pixel data (and backend packaging logic).

Although packets (packages) produced by the techniques disclosed herein may be larger than for traditional RLE as discussed above, the present techniques have been found to provide enhanced overall compression performance for various types of data values, for example those representing continuous-tone, colour images such as photographs or video. The techniques may also be useful for other types of data values, where the values vary in a similar fashion to those of such image data.

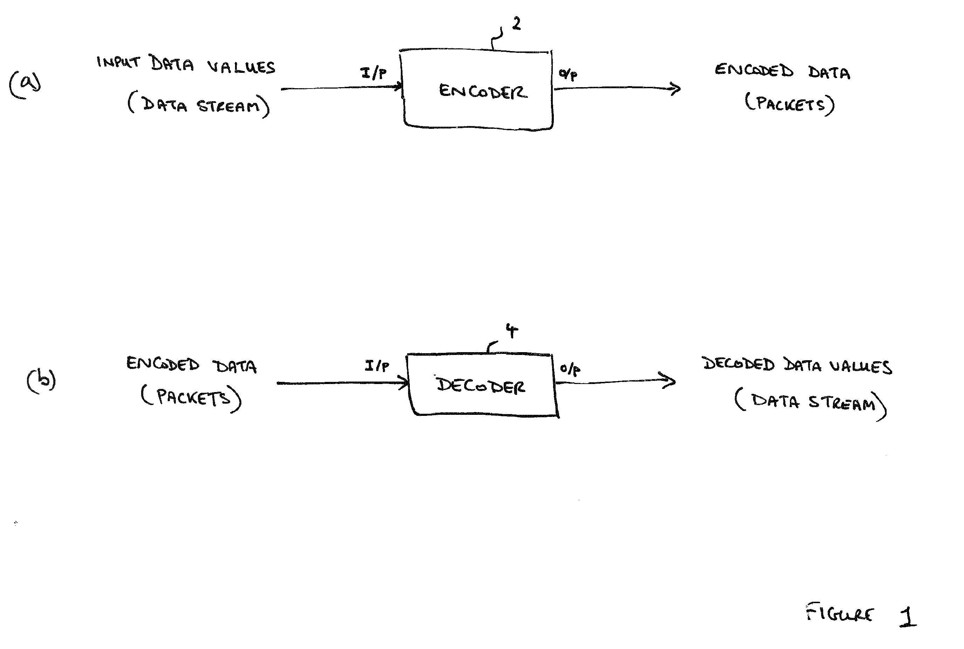

Figures 1(a) and 1(b) are schematic diagrams of an encoder 2 and a decoder 4, each of which embodies the present invention.

The encoder 2 is configured to receive at its input a stream of input data values, i.e., a data stream. Although encoder 2 may receive the input data values one-by-one (as may be expected in a data stream), it may also receive multiple data values simultaneously, i.e. in parallel. For example, encoder 2 may receive two or more data values at a time.

Encoder 2 is operable to receive and encode the input data values and to output encoded data (comprising encoded data values). The encoded data may be organised into packets. For example, such packets (or packages) may have a header portion and a payload portion.

Decoder 4 may be considered to perform a complementary function to the encoder 2. In particular, decoder 4 is configured to receive at its input encoder data, which may be organised into packets as discussed above. Further, decoder 4 is configured to decode the input encoded data, and output decoded data values. The output data values may be in the form of a data stream, akin to the data stream input to the encoder 2.

Encoder 2 may, in encoding the input data values, perform lossless or lossy compression. Where the encoder 2 performs lossless compression, the output encoded data, when decoded by decoder 4, may result in decoded data values which are the same as the original input data values (because no information content was lost in the compression). However, where the encoder 2 performs lossy compression, it will be appreciated that the output encoded data, when decoded by the decoder 4, may result in decoded data values which are similar to but not the same as all of the input data values (because some information content was lost in the compression).

Encoder 2 and decoder 4 may be provided separately, as in Figure 1, or in combination as an encoder/decoder which has the functionality of both. Encoder 2 and decoder 4 may be implemented in hardware (e.g. as wired logic), or for example in software such as by way of a computer program which, when executed on a processor, causes the processor to perform the functions of the encoder 2 and/or decoder 4. Of course, encoder 2 and decoder 4 may be implemented in a combination of hardware and software. It will be understood, however, that the encoding and decoding techniques disclosed herein are particularly suitable for implementation in hardware.

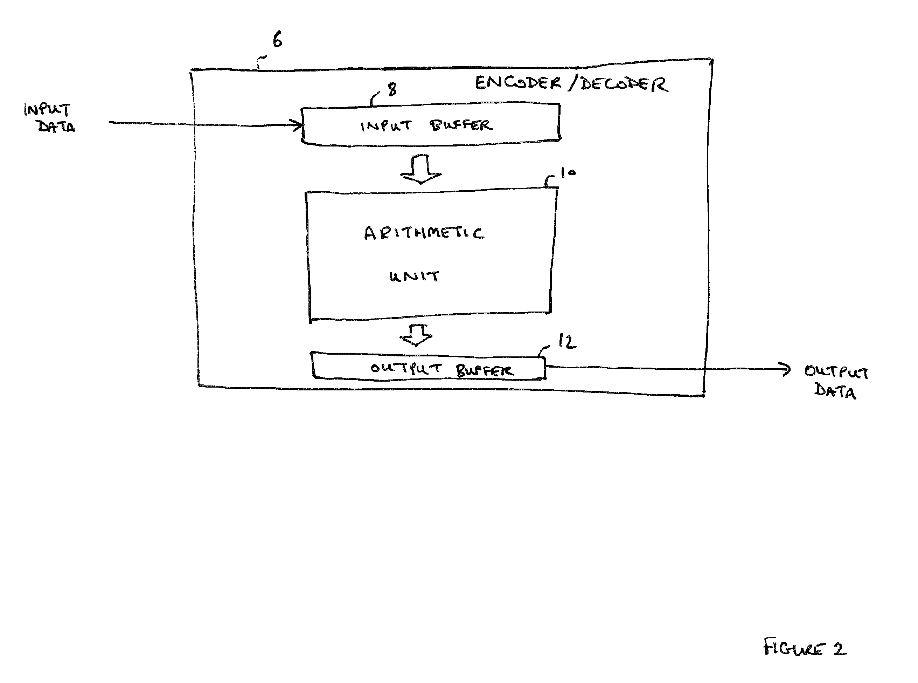

Figure 2 is a schematic diagram of an encoder/decoder 6 as implemented in hardware. It will be understood that encoder/decoder 6 may be configured to perform the functionality of one or both of encoder 2 and decoder 4. For example, it may be possible to configure encoder/decoder 6 to act as one or both of the encoder 2 and decoder 4, for example by setting values of stored parameters.

Encoder/decoder 6 comprises an input buffer 8, an arithmetic unit or block 10 and an output buffer 12. Encoder/decoder 6, when configured as encoder 2, is operable to receive input data values into the input buffer 8, to perform the encoding by way of arithmetic unit 10, and to output the encoded data by way of the output buffer 12. Similarly, when configured as decoder 4, encoder/decoder 6 is operable to receive encoded data into the input buffer 8, to perform the decoding by way of arithmetic unit 10, and to output the decoded data values by way of the output buffer 12.

Input buffer 8 and output buffer 12 may be implemented as FIFO (first-in-first-out) buffers. Moreover, input buffer 8 and output buffer 12 may be separate physical buffers, or may be implemented in the same physical buffer (for example, as separate parts of the same buffer, or by dividing usage of the same buffer between the input buffer 8 and the output buffer 12 over time).

Arithmetic unit 10 may be an ALU (Arithmetic and Logic Unit) and configured to perform arithmetic or logical operations so as to perform the required encoding and/or decoding. It may be implemented, for example as an integrated circuit, e.g. as (dedicated) wired logic. It may also be implemented as software (a computer program) running on processor, for example on a microcontroller.

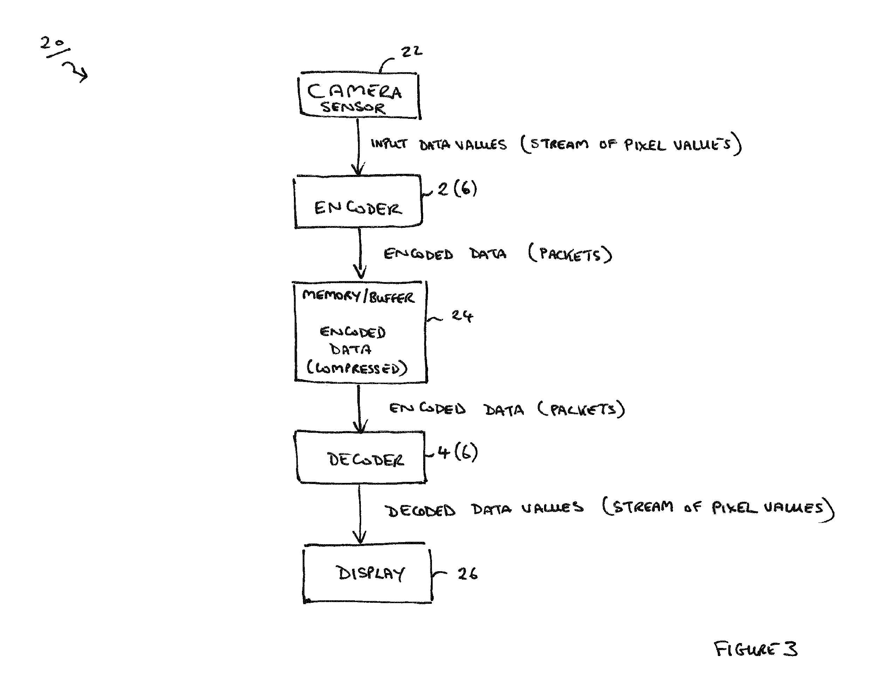

Figure 3 is a schematic diagram of a system 20, and represents an example application of the encoder 2 and decoder 4. System 20 comprises a camera sensor 22, a memory or buffer 24 and a display 26, as well as an encoder 2 and a decoder 4 (which may be implemented as an encoder/decoder 6).

Camera sensor 22 is operable to output a stream of pixel values, which make up images as sensed by the camera sensor 22. These pixel values are input as input data values to the encoder 2, which encodes them and outputs encoded data in the form of packets. This encoded data (representing a compressed form of the image data as provided by the sensor 22) may be stored in the memory or buffer 24.

When it is desired to view the images, the encoded data may be accessed from the memory or buffer 24 or input to the decoder 4, which decodes that data and outputs decoded data values. These output data values form a stream of pixel values again, which are input to the display 26.

Advantageously, as will become apparent, the encoding and decoding techniques disclosed herein are able to operate "on-the-fly", meaning that they can process a stream of pixel data (input data values) or encoded data as it is received, and do not for example require an addressable representation of the uncompressed data (input data values or decoded data values) or compressed data (encoded data values). Thus, for example, in the context of system 20 at no point is it necessary to store a complete or addressable copy of the original image data (pixel values, being the input data values) as output by the camera sensor 22.

Thus, it will be appreciated that in general embodiments of the present invention enable a reduction in the amount of memory needed to store a stream of input data values, for example the amount of memory needed for display and image buffers. Moreover, such embodiments also allow a reduction in the bandwidth needed to read and write to/from such memory. Particularly with increasing display resolutions (in the case of image data as in Figure 3), this brings significant benefit in terms of cost and complexity.

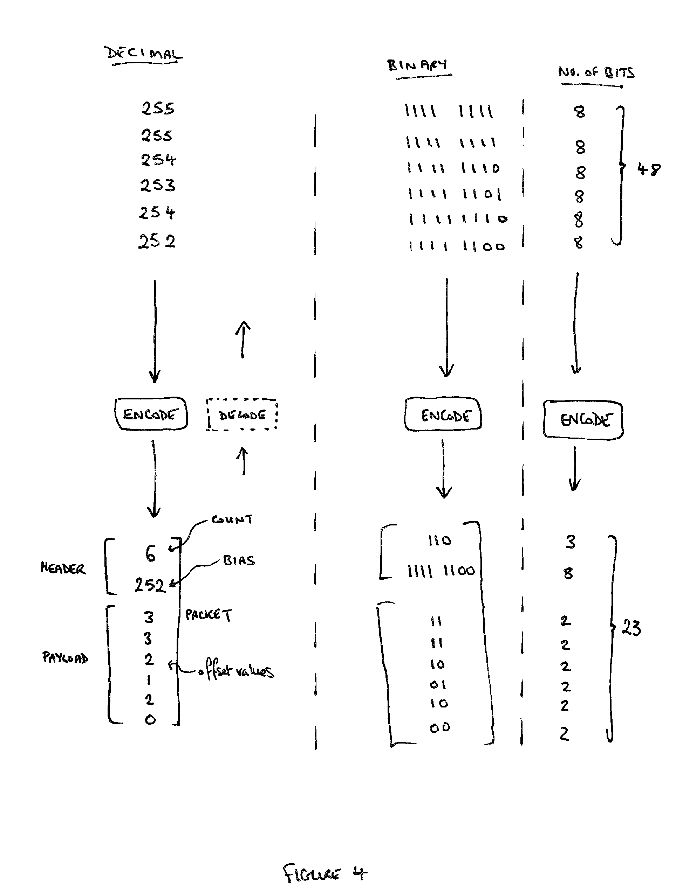

In order to better understand the techniques disclosed herein, reference will now be made to Figure 4.

Figure 4 shows how an example stream or series of input data values may be encoded. For ease of understanding, values are shown in decimal in the left-hand column and binary in the middle column, with the right-hand column indicating the number of bits used to represent each value. Given that in practice the values would be transferred and stored in binary, the compression effect (of the encoding) may be appreciated from the middle and right-hand columns particularly.

As indicated in the upper portion of Figure 4, the example input data values are (in decimal) 255, 255, 254, 253, 254, 252. These form a group of input data values. It is understood that these values are received in this order, such that the uppermost value is received for encoding first, and the lowermost value last. Of course, the values could equally be received in the reverse order.

As also indicated in the upper portion of Figure 4, each of these values is actually received in binary form as an 8-bit value. For example, decimal value 255 is received as binary value 1111 1111.

In the lower portion of Figure 4, a representation of a packet produced by way of encoding the input data values is presented. Thus, moving from the upper portion to the lower portion of Figure 4 represents encoding, as indicated. Conversely, moving from the lower portion to the upper portion represents decoding, also as indicated. Focus will however be placed on the encoding process, since it will be apparent therefrom how the decoding may be carried out.

In the present embodiment, the input data values are encoded to form a packet which comprises a count value, a bias value and a series of offset values, one per input data value.

The count value represents the number of input data values represented by the packet. The bias value is a value based on which the input data values may be calculated using the offset values. For example, the bias value may be set as the smallest value of the input data values. The offset values then each represent a value which, when added to the bias value, produces the input data value concerned.

Looking at the decimal example in Figure 4, the count value is 6 because the packet represents the group of 6 input data values. The bias value is 252, which is the smallest value of the input data values. The offset values are 3, 3, 2, 1, 2 and 0. For example, the sum of the first offset value 3 and the bias value 252 gives the first input data value 255, the sum of the second offset value 3 and the bias value 252 gives the second input data value 255, the sum of the third offset value 2 and the bias value 252 gives the third input data value 254, and so on and so forth.

The count value and bias value may be considered to form a header portion of the packet, and the offset values a payload portion.

Looking at the binary example in Figure 4, the count value 6 is represented by a 3-bit value, the bias value 252 is represented by an 8-bit value, and the offset values are each represented by 2-bit values. Thus, whereas the input data values take up 48 bits, the encoded packet takes up only 23 bits, but expresses the input data values without loss. Thus, this form of encoding performs lossless compression. Of course, in a practical embodiment the header portion may comprises further information (e.g. configuration parameters which are not shown in Figure 4), however the principle of compression remains. With a larger number of input data values represented by the packet, the compression rate could of course be higher.

For convenience and simplicity of implementation, the number of bits used to represent each offset value is kept the same within each packet, in this embodiment. In Figure 4, for example, all of the offset values are 2-bit values. Of course, a more complex embodiment may allow differing size values for the different offset values.

It will be appreciated that information (parameters) as to how many bits are used to express the count, bias and offset values may need to be sent with each packet, for example if these parameters may change from packet to packet. If, however, these parameters are kept constant for all packets, the information may be separately encoded into the encoder 2 and decoder 4 by way of configuration. Alternatively, if such parameters are kept constant only for a plurality of packets, and then changed for another plurality of packets for example, the parameters may be transmitted only when they change, for example by some separate "special" packets, extended headers or frame headers (or similar), or via a separate control channel.

The presence of the count value per packet (as in Figure 4) enables the number of input data values represented by each packet to be varied dynamically or on-the-fly, i.e. on a per-packet basis. For example, dependent on the range of values covered by a series of input data values, the encoder 2 may represent more or fewer input data values per packet. For example, the more input data values that are represented by a packet, the more shared out is the overhead of the packet header. However, the bigger the range of values covered by the input data values, the larger the number of bits needed to express the offset values. Therefore, for example, the encoder 2 may have stored therein (e.g., by configuration) a threshold number of bits to be used to express each offset value, and may represent as many input data values as possible (perhaps up to some limit) in one packet without exceeding that threshold, and start a new packet when needed.

Of course, it would be possible to configure encoder 2 and decoder 4 to express a fixed number of input data values per packet, in which case the count value need not be expressed per packet. Alternatively, the count value may be notified separately (as with the other parameters mentioned above, e.g., by separate packets, extended headers or frame headers (or similar), or via a separate control channel).

Similarly, it will also be appreciated that the bias value need not be included per packet. It may instead be notified in some other way, for example only when it changes. Thus, in some embodiments the packets may be effectively headerless.

In the decoding process, it will be appreciated that the count and bias values, and the other parameters mentioned above, allow the decoder 4 to identify complete packets and their component parts, and to reconstruct the input data values (without loss, in the present embodiment) by adding the offset values to the bias value.

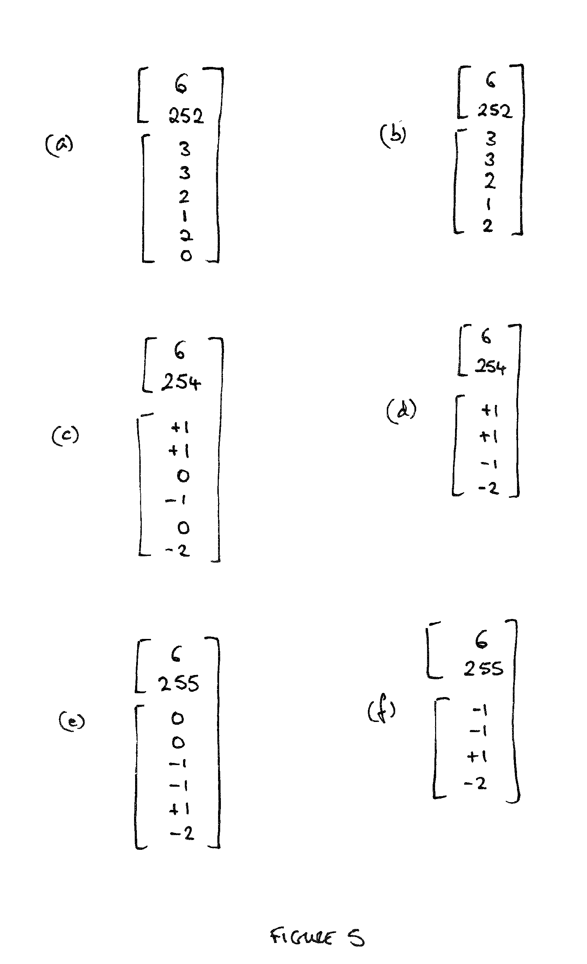

Figure 5 is a schematic diagram presenting various different packets which each encode the input data values in Figure 4 to further demonstrate that the invention may be embodied (implemented) in various different ways. Only the decimal values are shown for simplicity, however it will be appreciated that they would be expressed in binary form in a practical embodiment (for example, as shown in Figure 4).

The packet in Figure 5(a) is the same as that in Figure 4, and is reproduced simply to aid comparison with the other example packets.

The packet in Figure 5(b) is the same as that in Figure 5(a), except that the final offset value 0 is omitted. When input data values have the same value as the bias value, it may be possible to indicate this in some way in the header (or elsewhere) such that the corresponding offset values may be omitted. However, the added complexity in the header (or elsewhere) may make this undesirable. One simple way to implement this approach would be to make the bias value equal to the first or last input data value, such that as a rule the corresponding offset value could be omitted. However, in this case the offset values may include both negative and positive values for some packets (dependent on the input data values), which may also be undesirable.

Figure 5(c) presents an example package in which the bias value is not chosen as the smallest of the input data values. A value towards the middle of the range of input data values could for example be chosen. In the example, the value 254 is chosen, and as such the offset values include negative values. Of course, other values could be chosen as the bias value, however it is preferable to chose a value close to the input data values, to minimise the number of bits needed to express the offset values. In this respect, the format in Figure 5(a), in which the smallest input data value is used as the bias value, may be considered preferable, since it enables all of the offset values to be positive and at least one of them to be 0 (such that no more than the range of the input data values need be expressed by the offset values).

The packet in Figure 5(d) corresponds to that in Figure 5(c) in the same way that the packet in Figure 5(b) corresponds to that in Figure 5(a), in that zero-value offset values have been omitted. Thus, similar considerations as discussed in respect of Figure 5(b) apply.

Figure 5(e) presents an example packet in which the bias value is set as the same as the first input data value, and the offset values are incremental in the sense that each expresses the change from one input data value to the next. Thus, the first two offset values are 0, since the first two input data values are 255 (i.e., there is no change between them), the third offset value is -1, since the third input value is 254 (i.e., 1 less than 255). It will be appreciated that this approach is equivalent to each offset value having its own bias value, with the bias value indicated in the packet being the one for the first offset value, and the bias values for the subsequent offset values being calculated on-the-fly. Of course, the equivalent decoding process would start with the first offset value and the bias value indicated in the packet, and sum these to obtain the first decoded data value, and then add each successive offset value to the previous decoded data value to obtain the next decoded data value.

The packet in Figure 5(f) corresponds to that in Figure 5(e) in the same way that the packet in Figure 5(b) corresponds to that in Figure 5(a), in that zero-value offset values have been omitted. Thus, similar considerations as discussed in respect of Figure 5(b) apply.

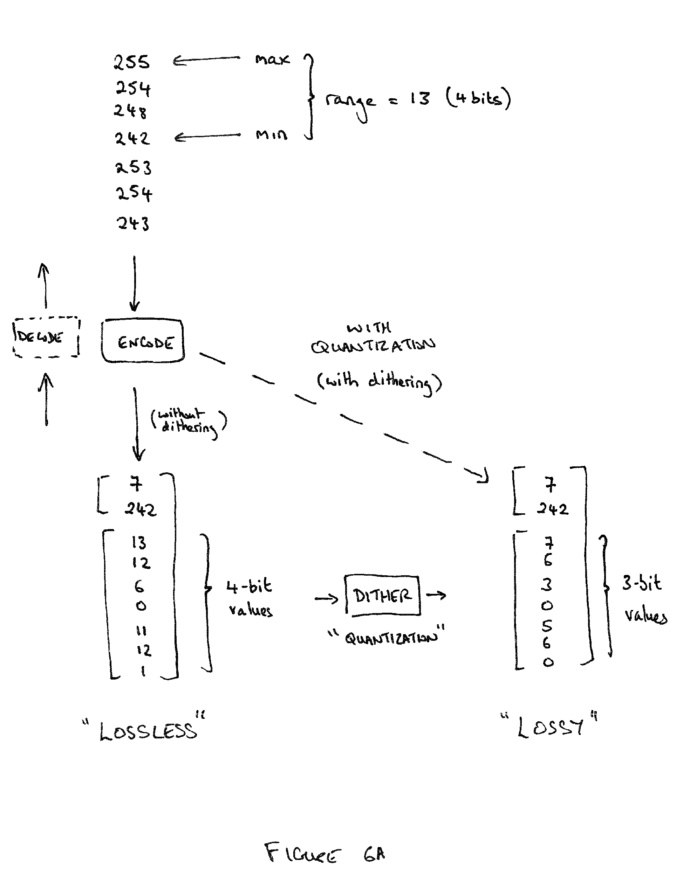

Figure 6A is similar to Figure 4, except that only decimal values are shown for simplicity, and that a different set of input data values is employed. Moreover, Figure 6A indicates that both lossless (as in Figure 4) and lossy encoding (compression) may be performed.

The left-hand column in Figure 6A follows a similar "lossless" encoding process as that in Figure 4, and this will first be explained to provide context for the further description.

As indicated in the upper portion of Figure 6A, the example input data values are (in decimal) 255, 254, 248, 242, 253, 254 and 243. As before, it is understood here that these values are received in this order, such that the uppermost value is received for encoding first, and the lowermost value last.

In the lower portion of Figure 6A, a representation of a packet produced by way of encoding the input data values is presented. Thus, moving from the upper portion to the lower portion of the left-hand column of Figure 6A represents encoding, as indicated. Conversely, moving from the lower portion to the upper portion of the left-hand column of Figure 6A represents decoding, as also indicated.

As in Figure 4, the packet in the left-hand column of Figure 6A comprises a count value, a bias value and a series of offset values, one per input data value. These values are used in the same way as in Figure 4, and thus duplicate description is omitted.

Looking at the decimal example in Figure 6A, in the left-hand column, the count value is 7 because the packet represents the 7 input data values. The bias value is 242, which is the smallest value of the input data values. The offset values are 13, 12, 6, 0, 11, 12 and 1. For example, the sum of the first offset value 13 and the bias value 242 gives the first input data value, the sum of the second offset value 12 and the bias value 242 gives the second input data value, and so and so forth.

The point to note in the left-hand column of Figure 6A is that the offset values would be expressed as 4-bit values in order to provide lossless compression. That is, the first offset value 13 (in decimal) may be expressed as 1101 (in binary). This is also the largest offset value, and equal to the range covered by the input data values, as also indicated in Figure 6A.

However, it may be that for some reason it is not desirable to use such 4-bit values. For example, it may be that more compression is needed because of memory or bandwidth constraints or that a known data rate which would be achieved by a lower number of bits per offset value such as 3-bit values is desired.

Embodiments of the present invention enable this to be achieved by quantization. That is, the 4-bit offset values as in the left-hand column may be expressed as 3-bit values by way of quantization.

This inevitably involves some rounding. For example, the full range of values 0 to 15 as may be expressed by 4-bit values must be reduced to 8 values (0 to 7) as expressible by 3-bit values, for example with the decimal values 0 to 7 (3-bit values) corresponding to the decimal values 0, 2, 4, 6, 8, 10, 12 and 14 from the 4-bit space.

This quantization or rounding has been carried out on the left-hand packet in Figure 6A to create the right-hand packet, in a more-or-less arbitrary fashion simply to show that rounding may be carried out.

The important point to note, however, is that this process is lossy. Information is lost in the quantization process, which information cannot be fully regained.

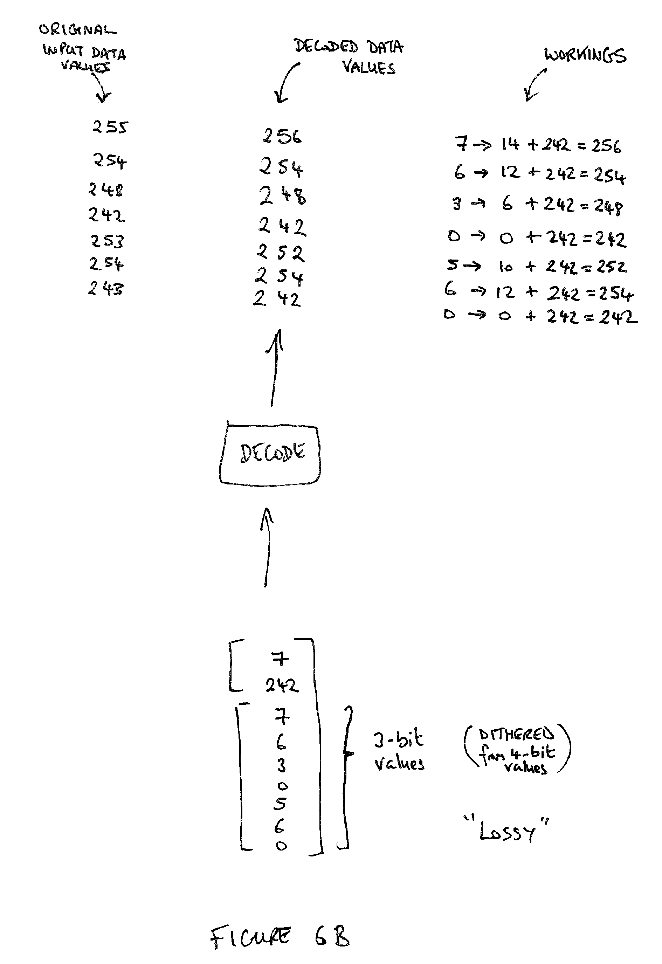

Figure 6B is a schematic diagram provided to demonstrate this loss based on the right-hand packet in Figure 6A. For convenience, the right-hand packet in Figure 6A is reproduced at the bottom of Figure 6B.

The decoding process is then explicitly indicated (with the workings shown), to arrive at the decoded data values in the upper half. Firstly, the 3-bit offset values 7, 6, 3, 0, 5, 6 and 0 (in decimal) are converted to the 4-bit equivalents 14, 12, 6, 0, 10, 12 and 0, respectively. These are then added to the bias value 242 to arrive at the decoded data values as shown.

To illustrate the loss of information, the original input data values are reproduced alongside the decoded data values. As is clear, some of the corresponding values are the same whereas others are different. Where there are differences, information has been lost.

In effect, this quantization (in the context of colour image data) reduces the number of colours which may be expressed in the decompressed image data.

In order to produce a better end image quality, however, with fewer perceptible artefacts such as banding or similar, it is envisaged that the quantization could be employed in combination with dithering, for example to give a smoother end image which appears to have a larger number of colours and has reduced banding artefacts. Dithering may also be used for other types of data, for example for audio data, however its benefits are readily appreciated in the context of image data.

For the benefit of understanding, and as an aside, dither is an intentionally applied form of noise used to randomize quantization error, preventing large-scale patterns such as colour banding in images. It creates the illusion of colour depth in images with a limited colour palette (colour quantization). In a dithered image, colours not available in the palette are approximated by a diffusion of colour pixels from within the available palette. The human eye perceives the diffusion of a mixture of the colours within it. By its nature, dithering typically introduces a pattern into the image, and the idea is that the image is viewed from such a distance that the pattern is not discernable to the human eye.

In the context of the present invention as concerns image data, and looking at Figure 6A, if the original 4-bit offset values are simply translated into the closest available value from the 3-bit range (cf. reduced palette), no dithering occurs. Typically, this approach results in flat areas in the eventual decoded image and a loss of detail, and may produce patches of colour that are significantly different from the original. Shaded or gradient areas may appear as colour bands, which may be distracting. The application of dithering can help to minimise such visual artefacts, and usually results in a better representation of the original. That is, dithering helps to reduce colour banding and flatness, and other such artefacts.

Such dithering may be spatial, in which the smoothness is achieved by controlling the rounding process across pixels in a single image, or temporal, in which a similar effect is achieved by alternating each pixels colour value rapidly (i.e. over time) between two approximate values in the available values space (e.g., colour palette).

Many algorithms for performing dithering are known, and may be applied in the present invention. For example, known techniques include random dithering, fixed-pattern dithering, ordered dithering (using a "dither matrix") and error-diffusion dithering. A Bayer matrix employed as a dither matrix may, for example, be used.

Thus, it will be appreciated that the encoding of the present invention may operate in one or both of lossless and lossy (with or without dithering) modes. In the context of image data, a mode may be used for an entire image, or the mode may be changed during processing of the image data. Thus, some parts of an image may be encoded in a lossless manner, and others in a lossy manner.

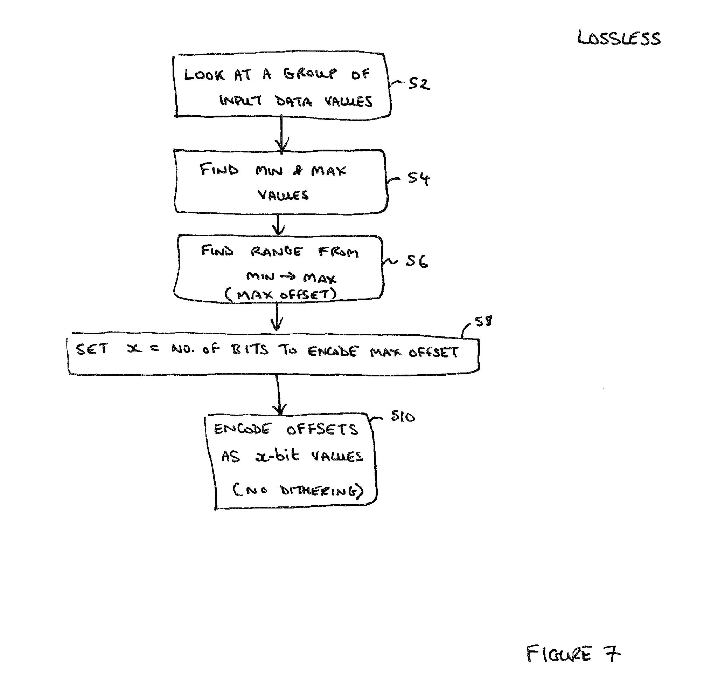

Figures 7 to 10 are examples of embodiments in which one or both of such modes are employed. For the sake of convenience, in the following examples it is assumed that dithering is employed wherever lossy encoding is carried out. It will also be appreciated that although these examples appear to consider generation of a single packet, they may be repeated to generate further packets from further input data values. In this way, an entire image, or series of images, may be encoded to produce a series of packets.

Figure 7 presents an example in which "lossless" encoding is employed, and corresponds to the example of Figure 4.

In step S2, a group of input data values is analysed or examined, such as the group in Figure 4 or 6A. In step S4 the maximum and the minimum values are identified, for example as explicitly indicated in Figure 6A. In step S6, the range from the minimum value to the maximum value is found, this corresponding to the maximum offset value that need be expressed in the eventual packet. Again, this is shown in Figure 6A. Accordingly, in step S8, the number of bits required to encode or express this maximum offset value is identified (e.g. 3-bits to express a maximum offset value of 7), and this number is taken as the value of X (e.g., X = 3). In step S10, the offset values ("offsets") are encoded (expressed) as X-bit values, e.g., as 2-bit values as in Figure 4. The encoding is lossless.

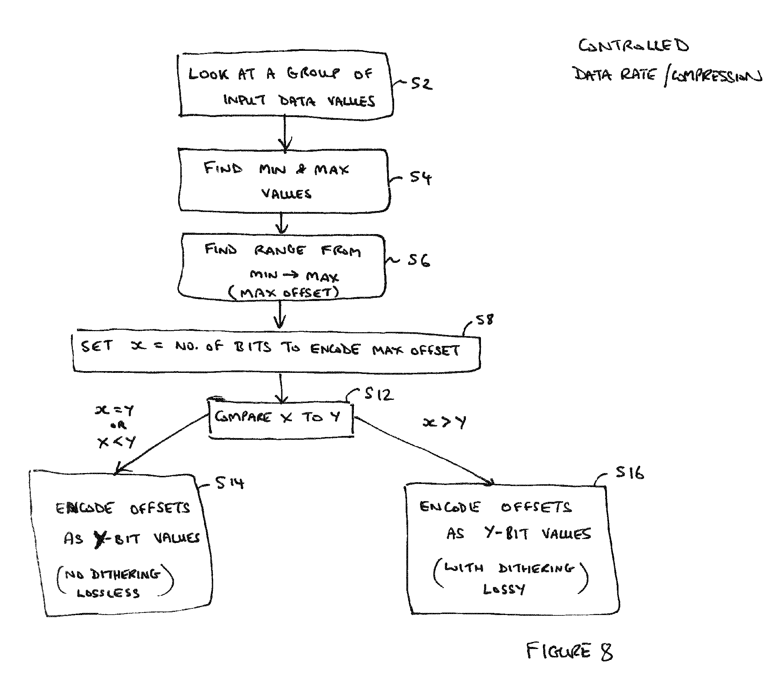

Figure 8 presents an example in which encoding having a controlled data rate or compression rate (performance target) is desired. Steps S2 to S8 are the same as in Figure 7.

In step S12, the value X is compared to a value Y, where it is assumed that using Y-bit values for the offset values would give the desired data rate or compression rate. In step S14, where X=Y or X<Y, the offset values are encoded (expressed) by Y-bit values, and the encoding is lossless. In step S16, where X>Y, the offset values are encoded (expressed) as Y-bit values, by way of quantization with dithering, and the encoding is lossy.

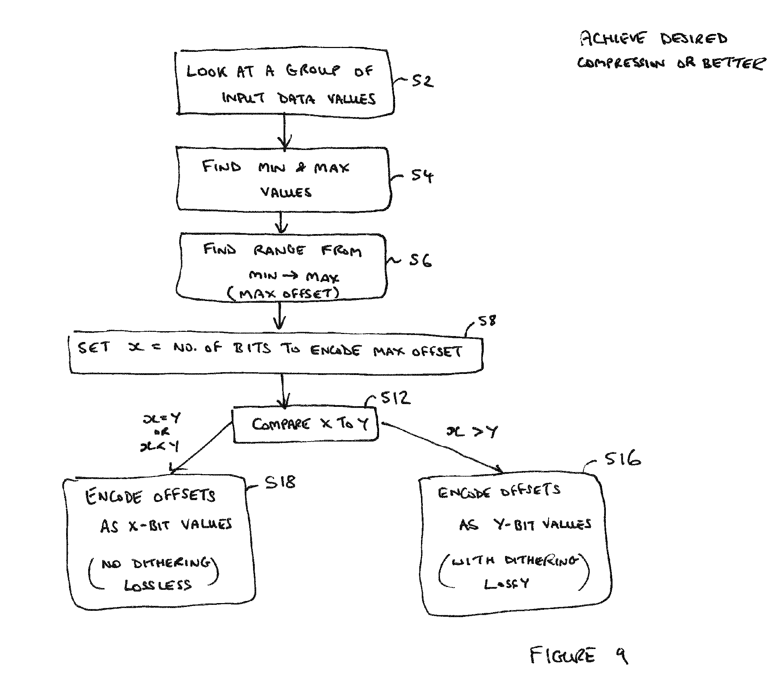

Figure 9 presents an example in which encoding which would achieve a particular compression rate or better (performance target) is desired. Steps S2 to S8 and S12 are the same as in Figure 8, although it is assumed that using Y-bit values for the offset values would give at least the particular compression rate.

In step S18, where X=Y or X<Y, the offset values are encoded (expressed) by X-bit values to achieve the particular compression rate (X=Y) or better (X<Y), and the encoding is lossless. In step S16, where X>Y and which is the same as in Figure 8, the offset values are encoded (expressed) as Y-bit values, by way of quantization with dithering to achieve at least the particular compression rate, and the encoding is lossy.

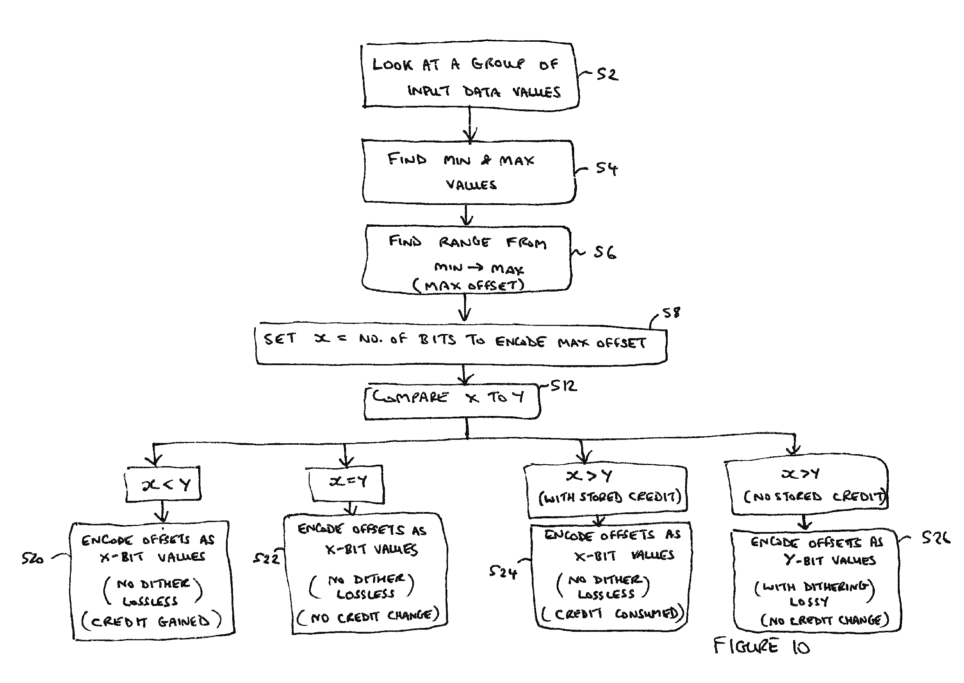

Figure 10 presents an example in which encoding that achieves at least a target average compression rate over time (performance target) is desired. Thus, Figure 10 is best understood in that it may be repeated many times, generating many packets, for example to encode an entire image or series of images packet-by-packet.

Steps S2 to S8 and S12 are the same as in Figures 8 and 9, although here it is assumed that using Y-bit values for the offset values on average would give the desired target average compression rate.

As will be appreciated, this example assumes a running "credit" system, in which credit may be gained or consumed over time. The encoder 2 may be configured to operate the credit system, for example to monitor the amount of credit in the credit system over time.

In step S20, where X<Y, the offset values are encoded (expressed) as X-bit values and the encoding is lossless. Because the compression rate for the packet concerned is better than the target average (X<Y), it is assumed that credit is gained in the credit system.

In step S22, where X=Y, the offset values are encoded as X-bit values, and the encoding is again lossless. As this achieves the desired target average for the packet concerned (X=Y), credit is neither gained nor consumed in the credit system.

In step S24, where X>Y and there is credit stored in the credit system, the offset values are encoded (expressed) as X-bit values and the encoding is lossless. This is carried out because credit in the credit system indicates that the running average compression rate is below the target, and thus that some further lossless compression can be tolerated without exceeding the target. However, as this is increasing the running average compression rate towards the target, credit is consumed in the credit system to indicate that the flexibility to tolerate further such lossless compression is reducing.

In step S26, where X>Y and there is no stored credit in the credit system, the offset values are encoded (expressed) as Y-bit values, by way of quantization with dithering to achieve the target average compression rate. Credit is neither gained nor consumed.

In a hardware implementation, it may be desirable never to allow the credit system to go into negative credit, to ensure the target compression rate or better by the end of an image (or the end of a series of groups of input data values). This is because, for example, in a hardware implementation it may not be known what the properties of the yet to be encoded input data values are. However, a software implementation may allow negative credit as it makes several passes of the input data values (e.g. of an image) to find optimal encoding.

Incidentally, in step S24, the offset values could be encoded as Z-bit values, where Y<Z<X, with credit being consumed at a lesser rate. Similarly, in step S20, the offset values could be encoded as Z-bit values, where X<Z<Y, with credit being gained at a lesser rate. Other variations are of course possible. For example, in step S26, the offset values could be encoded as Z-bit values, where Z<Y, with more severe quantization and a gain in credit.

An example implementation will now be considered. The packets are referred to as packages, and a series of packages may be preceded by a frame header. Image data will also be assumed as a convenient example.

Frame header:

| mode<2> | 0 = RLAD (Run-Length Adaptive Dithering; lossy)<br>1 = RLAD_UNIFORM (RLAD with constant package size)<br>2 = RLA (Run-Length Adaptive; lossless) |
|---|---|
| width<14><br>height<14> | Frame dimension in pixels. Allowed values: 1..16383. |
| bpc0<4><br>bpc1<4><br>bpc2<4><br>bpc3<4> | Number of uncompressed bits per color channel. Allowed values: 0..8.<br><br>Channel 0 = R or Y, channel 1 = G or U, channel 2 = B or V, channel 3 = A |

(continued)

| cbpc0_max<4> cbpc1_max<4> cbpc2_max<4> cbpc3_max<4> | Maximum number for compressed bits per color channel. Allowed values: 0..8. This is ignored for RLA mode. |
|---|---|

This data could be stored either at the beginning of the compressed bit stream (less complex for software) or as part of the encoder and decoder configuration (less complex for hardware). The numbers in brackets < > are numbers of bits, but could be numbers of other groupings (e.g. bytes, words).

From this the size of cbpc fields in package headers computes to

$$\text{cbpc[i]\_width} = 0 \quad \text{if} \quad \text{bpc[i]}=0$$

$$= \text{floor(log2(bpc[i])} + 1) \quad \text{otherwise}$$

This corresponds to index of most significant '1' in bpc plus 1.

Package header:

| type<1> | Type of compressed pixel data: 0 = offsets to bias |
|---|---|
| | 1 = deltas to previous pixel Field only exists for RLA mode. For RLAD modes its value is constant 0 (offset type). |
| cnt<5> | Number of pixels store in this package less one (1..32 pixels per package). Field only exists for RLA mode. For RLAD modes its value is set to constant 7 (= 8 pixels per package). |
| cbpc0<cbpc0_width> cbpc1<cbpc1_width> cbpc2<cbpc2_width> cbpc3<cbpc3_width> | Number of compressed bits per channel of lossless image representation. |
| col0_bias<bpc0> col1_bias<bpc1> col2_bias<bpc2> col3_bias<bpc3> | Bias value for all channels. |

From this the number of pixels stored in the package computes to

$$pcnt = \min(cnt\_bias + cnt + 1, width - xfirst)$$

where $xfirst$ is the column index of the first pixel stored in the package. This considers that a package always ends at end of line. The number of bits that is stored for each channel and pixel is

$$pbpc[i] = cbpc[i] \quad \text{[RLA mode]}$$

$$pbpc[i] = cbpc[i]\_max \quad \text{[RLAD\_UNIFORM mode]}$$

In RLAD mode, which uses credit, an internal state $credit$ should preferably be managed (initialized to null at start of frame; shared by all channels):

$$d = cbpp - cbpp\_max$$

$$\text{if } (d \leq 0) \text{ or } (d \leq credit)$$

$$credit = credit - d$$

$$pbpc[i] = cbpc[i]$$

$$\text{else } pbpc[i] = cbpc\_max[i]$$

where

$$cbpp = cbpc0 + cbpc1 + cbpc2 + cbpc3$$

$$cbpp\_max = cbpc0\_max + cbpc1\_max + cbpc2\_max + cbpc3\_max$$

The credit counter allows the encoder a more efficient compression in case of inhomogeneous image material. For example, when a region of the image can be compressed without loss of information with a compression rate even below what is given by *cbpc_max* values, the credit counter will grow. Following regions, that would result in lossy compression, can then use existing credit to continue with lossless data packaging.

Package (payload) data:

| | |
|---|---|
| *cdat0<pbpc0>* [0]<br>*cdat1<pbpc1>*[0]<br>*cdat2<pbpc2>*[0]<br>*cdat3<pbpc3>*[0] | Compressed color data for each channel of first package pixel. |
| ... | |
| *cdat0<pbpc0>* [*pcnt*-1]<br>*cdat1<pbpc1>* [*pcnt*-1]<br>*cdat2<pbpc2>*[*pcnt*-1]<br>*cdat3<pbpc3>*[*pcnt*-1] | Compressed color data for each channel of last package pixel. |

Decompression of color data:

$$dat[i][k] = cdat[i][k] * (2^{\wedge}cbpc[i]-1) / (2^{\wedge}pbpc[i]-1)$$

This up-scales *cdat* from *pbpc* to cbpc bit resolution, which can differ in case of lossy compression. In hardware this can simply be implemented by MSBit replication instead of using multipliers and dividers. In any case it should preferably be ensured, that lowest and highest values in both resolutions map to each other (0 to 0 and max code to max code).

Computation of final color value for each pixel and color channel in a package when *type*=0 (offset mode):

$$col[i][k] = col[i]\_bias + dat[i][k]$$

When *type*=1 (delta mode) the computation is different:

$$col[i][0] = col[i]\_bias$$

$$col[i][k] = col[i][k-1] + dat[i][k] - dat[i][0]$$

So instead of storing signed delta values as two's complement, data of the first pixel (which is not needed, because first pixel is equal to bias value) is used as a negative offset to positive data values stored in the package stream. This allows more efficient use of the data fields, because data range of two's complement values is always symmetric around null, while the offset based approach can be optimized for the actual distribution of negative and positive delta values that occur.

In both modes the final result should preferably be truncated to the target bit resolution bpc (not clamped):

$$col[i][k] \mathrel{\&=} (2^{\wedge}bpc[i]\text{-}1)$$

This allows the encoder to utilize wrap-around at this point in case of lossless compression (RLAD), which is particularly efficient for black & white like content such as this text.

The algorithm for RLAD encoding is straightforward and elegant since the package size in particular embodiments may be constant in number of pixels. Thus, the encoder may just collect color values of 8 consecutive pixels (to form a packet or package) and determine the minimum and maximum values for each color channel. From that the package parameters can directly be computed.

The maximum for compression rate is adjusted by setting up the cbpc_max[i] values. The required buffer size in bits then computes to:

$$cnt = 8$$

$$header\_size = ( cbpc0\_width + cbpc1\_width + cbpc2\_width + cbpc3\_width) +( bpc0 + bpc1 + bpc2 + bpc3)$$

$$num\_package =(width/cnt +( (width\%cnt > 0)?1:0)) * height$$

$$max\_buf\_size =num\_package * header\_size + width * height * (cbpc0\_max + cbpc1\_max + cbpc2\_max + cbpc3\_max)$$

The actual size may be lower depending on the image content.

When data values must be reduced in order to achieve the given limit, this may be done by spatial Bayer dithering with contrast correction. In that case, the encoder should preferably ensure that no overshoots beyond the maximum color code can occur by dithering, because this can lead to minor brightness reduction in the decoder when only parts of a dither pattern are clamped to the maximum code.

For lossless compression there may be much more variance for encoders if there is variable package size. An algorithm may be configured to package an image for best overall compression result.

It will be appreciated that hardware implementations may in practice be optimized for gate count (stream-able; no large buffers), whereas software implementations may achieve higher compression rates.

A well balanced RLAD encoder setup for RGB compression may be cbpc0/1/2_max = 3/4/3, which achieves a compression rate of approximately 60% at PSNR values clearly above 30 dB.

In general, RLAD compression in YUV space may be a good choice for video material, since adjacent chroma values typically have stronger correlation than channels that scale with luma such as R, G and B. Although the benefits of dithering may seem questionable for chroma bit reduction, it does not seem to result in distracting artifacts in practice. The overall result when comparing YUV to RGB compression at same rate has been found to look better for YUV.

The present techniques are advantageous, in that they reduce the amount of memory needed to store static image data, reduce the amount of memory needed to store dynamic data such as video streams, reduce the bandwidth required to read and write all these data, reduce the gate count and power consumption needed for correlated encoder and decoder hardware, and keep image quality of compressed data at a high level.

In any of the above aspects, the various features may be implemented in hardware (e.g. with wired logic, without use of a processor), and/or as software modules running on one or more processors. Features of one aspect may be applied to any of the other aspects.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

**Claims**

1.  A method of encoding Q-bit input data values, where Q is an integer greater than 1, the method comprising:

    outputting an encoded data value for each of said input data values, where each encoded data value represents an offset to the corresponding input data value from a bias value closer to that input value than the value zero and is expressed as an R-bit value, where R is an integer greater than or equal to 1 and less than Q.

2.  A method as claimed in claim 1, comprising:

    for a group of said input data values, selecting a group bias value, and outputting such an encoded data value per input data value where each encoded data value represents an offset to the corresponding input data value from the group bias value or from another bias value obtainable by combining the group bias value and one or more of the encoded data values.

3.  A method as claimed in claim 1 or 2, comprising:

    for such a group of said input data values, selecting a group bias value common to those input values, and outputting such an encoded data value per input data value where each encoded data value represents an offset to the corresponding input data value from the group bias value.

4.  A method as claimed in claim 1 or 2, comprising:

    for such a group of said input data values, the input data values of the group being organised into an order, selecting a group bias value, and outputting an encoded data value per input data value,
    wherein:

        the encoded data value for the first input data value in said order represents an offset to that input data value from the group bias value; and
        the encoded data value for each subsequent input data value in said order represents an offset to that input data value from its own bias value being equal to the preceding input data value in the order or equal to the sum of the offset value and the bias value for the preceding input data value in said order.

5.  A method as claimed in claim 2, 3 or 4, comprising:

    for said group of input data values, selecting the group bias value to be equal to the smallest input data value of the group, or equal to another input data value of the group, or equal to a value dependent on some or all of the input data values of the group; and/or
    for said group of input data values, the number of input data values in the group being a count value, outputting the encoded data values with said count value and said group bias value; and/or
    Q being the same for each input data value of the group; and/or
    R being the same for each encoded data value of the group.

6.  A method as claimed in any of claims 2 to 5, wherein R is equal to or less than a value Z being the minimum value or another value sufficient to express the offsets for said group without loss, the method comprising optionally controlling the number of input data values in the group so that Z is below a given limit.

7. A method as claimed in claim 6, wherein, when R is less than Z, said encoded data values are expressed as R-bit values by quantization with respect to corresponding Z-bit values, optionally by such quantization with dithering.

8. A method as claimed in claim 6 or 7, comprising setting R to be equal to Z when setting R to be equal to Z at least meets a performance target, and setting R to be less than Z when setting R to be less than Z would meet the performance target but setting R to be equal to Z would not meet the performance target.

9. A method as claimed in any of claims 6 to 8, comprising, outputting encoded data values for a series of said groups, and setting R to be equal to or less than Z on a group-by-group, or input data value-by-input data value, basis.

10. A method as claimed in claim 9, comprising, given a performance target to be met on average over at least the series of groups, setting the value of R to be equal to or less than Z dynamically on a group-by-group basis in order to meet the performance target on average over the series of groups and to suppress loss by quantization.

11. A method as claimed in claim 10, comprising:

maintaining a credit count whilst encoding the series of groups, the credit count being indicative of whether or not the running performance meets the performance target; and
on a group-by-group basis, setting R to be equal to or less than Z in dependence upon the credit count.

12. A method as claimed in any of the preceding claims, wherein:

the input data values are received as a stream of input data values, the method comprising encoding said input data values on-the-fly, one-by-one or group-by-group; and/or
the input data values are image data values, and the encoded data values are compressed image data values.

13. A method of decoding encoded data values, where each encoded data value represents an offset to a corresponding target data value from a bias value other than zero, the method comprising combining each encoded data value with its bias value to obtain the corresponding target data value.

14. An encoder for encoding Q-bit input data values, where Q is an integer greater than 1, the encoder being operable to output an encoded data value for each of said input data values, where each encoded data value represents an offset to the corresponding input data value from a bias value closer to that input value than the value zero and is expressed as an R-bit value, where R is an integer greater than or equal to 1 and less than Q.

15. A method of encoding a series of input data values in order to meet a performance target on average over the series, the method comprising:

outputting an encoded data value for each of said input data values, where each encoded data value is expressed as an R-bit value; and
setting the value of R dynamically in order to meet the performance target.

**Amended claims in accordance with Rule 137(2) EPC.**

1. A method of on-the-fly encoding Q-bit input data values which are received as a stream of input data values, where Q is an integer greater than 1, the method comprising outputting encoded data values for a series of groups of said input data values, wherein:

an encoded data value is output for each of said input data values;
each encoded data value represents an offset to the corresponding input data value from a bias value closer to that input value than the value zero and is expressed as an R-bit value, where R is an integer greater than or equal to 1;
for some or all of said encoded data values, R is less than Q;
for each said group of input data values, a group bias value is selected, and each output encoded data value represents an offset to the corresponding input data value from the group bias value or from another bias value obtained by combining the group bias value and one or more of the encoded data values;
R is set to be greater than (S14), equal to (S18, S20, S22, S24) or less than (S16, S26) a value Z dynamically on a group-by-group, or input data value-by-input data value, basis, where Z is the minimum value sufficient to express the offsets for said group without loss; and

for at least some said encoded data values R is less than Z, and when R is less than Z the encoded data values are expressed as R-bit values by quantization with dithering (S16, S26) with respect to corresponding Z-bit values.

2. A method as claimed in claim 1, comprising:

for a said group of said input data values, selecting a group bias value common to those input values, and outputting such an encoded data value per input data value where each encoded data value represents an offset to the corresponding input data value from the group bias value.

3. A method as claimed in claim 1, comprising:

for a said group of said input data values, the input data values of that group being organised into an order, selecting a group bias value, and outputting an encoded data value per input data value, wherein:

the encoded data value for the first input data value in said order represents an offset to that input data value from the group bias value; and

the encoded data value for each subsequent input data value in said order represents an offset to that input data value from its own bias value being equal to the preceding input data value in the order or equal to the sum of the offset value and the bias value for the preceding input data value in said order.

4. A method as claimed in any of the preceding claims, comprising:

for a said group of input data values, selecting the group bias value to be equal to the smallest input data value of that group, or equal to another input data value of that group, or equal to a value dependent on some or all of the input data values of that group.

5. A method as claimed in any of the preceding claims, comprising:

for a said group of input data values, the number of input data values in that group being a count value, outputting the encoded data values with said count value and said group bias value.

6. A method as claimed in any of the preceding claims, comprising:

for a said group of input data values, Q being the same for each input data value of that group.

7. A method as claimed in any of the preceding claims, comprising:

for a said group of input data values, R being the same for each encoded data value of that group.

8. A method as claimed in any of the preceding claims, comprising controlling the number of input data values in each group so that Z is below a given limit.

9. A method as claimed in any of the preceding claims, comprising setting R to be equal to Z when setting R to be equal to Z at least meets a performance target, and setting R to be less than Z when setting R to be less than Z would meet the performance target but setting R to be equal to Z would not meet the performance target.

10. A method as claimed in any of the preceding claims, comprising, given a performance target to be met on average over at least the series of groups, setting the value of R to be equal to or less than Z dynamically on a group-by-group basis in order to meet the performance target on average over the series of groups and to suppress loss by quantization.

11. A method as claimed in claim 10, comprising:

maintaining a credit count whilst encoding the series of groups, the credit count being indicative of whether or not the running performance meets the performance target; and
on a group-by-group basis, setting R to be equal to or less than Z in dependence upon the credit count.

**12.** A method as claimed in claim 11, comprising:

encoding said input data values a plurality of times, each time encoding the input data differently and each time allowing the credit count to become negative, to find optimal encoding; or
performing the encoding such that the credit count never becomes negative.

**13.** A method as claimed in any of the preceding claims, wherein:

the input data values are image data values, and the encoded data values are compressed image data values.

**14.** An encoder (2; 6; 20) for on-the-fly encoding Q-bit input data values which are received as a stream of input data values, where Q is an integer greater than 1, the encoder being operable to output encoded data values for a series of groups of said input data values, and being configured such that:

an encoded data value is output for each of said input data values;
each encoded data value represents an offset to the corresponding input data value from a bias value closer to that input value than the value zero and is expressed as an R-bit value, where R is an integer greater than or equal to 1;
for some or all of said encoded data values, R is less than Q;
for each said group of input data values, a group bias value is selected, and each output encoded data value represents an offset to the corresponding input data value from the group bias value or from another bias value obtained by combining the group bias value and one or more of the encoded data values;
R is set to be greater than (S14), equal to (S18, S20, S22, S24) or less than (S16, S26) a value Z dynamically on a group-by-group, or input data value-by-input data value, basis, where Z is the minimum value sufficient to express the offsets for said group without loss; and
for at least some said encoded data values R is less than Z, and when R is less than Z the encoded data values are expressed as R-bit values by quantization with dithering (S16, S26) with respect to corresponding Z-bit values.

**15.** Image-handling apparatus (20), comprising an encoder (2; 6) as claimed in claim 14.

EP 2 819 412 A1

(a)  INPUT DATA VALUES
     (DATA STREAM)  — I/P → | ENCODER $_2$ | o/p → ENCODED DATA
                                                    (PACKETS)

(b)  ENCODED DATA
     (PACKETS)  — I/P → | DECODER $_4$ | o/p → DECODED DATA VALUES
                                                    (DATA STREAM)

FIGURE 1

ENCODER/DECODER

INPUT DATA →

INPUT BUFFER

ARITHMETIC UNIT

OUTPUT BUFFER → OUTPUT DATA

6

8

10

12

FIGURE 2

EP 2 819 412 A1

20
22

CAMERA SENSOR

INPUT DATA VALUES (STREAM OF PIXEL VALUES)

ENCODER 2(6)

ENCODED DATA (PACKETS)

MEMORY/BUFFER

ENCODED DATA (COMPRESSED) 24

ENCODED DATA (PACKETS)

DECODER 4(6)

DECODED DATA VALUES (STREAM OF PIXEL VALUES)

DISPLAY 26

FIGURE 3

EP 2 819 412 A1

DECIMAL

BINARY

NO. OF BITS

| | | | |
|---|---|---|
| 255 | 1111 1111 | 8 |
| 255 | 1111 1111 | 8 |
| 254 | 1111 1110 | 8 |
| 253 | 1111 1101 | 8 |
| 254 | 1111 1110 | 8 |
| 252 | 1111 1100 | 8 |

48

ENCODE    DECODE          ENCODE          ENCODE

HEADER
6 — COUNT
252 — BIAS

PAYLOAD
3 — PACKET
3
2 — offset values
1
2
0

| | | |
|---|---|---|
| 110 | | 3 |
| 1111 1100 | | 8 |
| 11 | | 2 |
| 11 | | 2 |
| 10 | | 2 |
| 01 | | 2 |
| 10 | | 2 |
| 00 | | 2 |

23

FIGURE 4

(a) $\begin{bmatrix} 6 \\ 252 \end{bmatrix}$ $\begin{bmatrix} 3 \\ 3 \\ 2 \\ 1 \\ 2 \\ 0 \end{bmatrix}$

(b) $\begin{bmatrix} 6 \\ 252 \end{bmatrix}$ $\begin{bmatrix} 3 \\ 3 \\ 2 \\ 1 \\ 2 \end{bmatrix}$

(c) $\begin{bmatrix} 6 \\ 254 \end{bmatrix}$ $\begin{bmatrix} +1 \\ +1 \\ 0 \\ -1 \\ 0 \\ -2 \end{bmatrix}$

(d) $\begin{bmatrix} 6 \\ 254 \end{bmatrix}$ $\begin{bmatrix} +1 \\ +1 \\ -1 \\ -2 \end{bmatrix}$

(e) $\begin{bmatrix} 6 \\ 255 \end{bmatrix}$ $\begin{bmatrix} 0 \\ 0 \\ -1 \\ -1 \\ +1 \\ -2 \end{bmatrix}$

(f) $\begin{bmatrix} 6 \\ 255 \end{bmatrix}$ $\begin{bmatrix} -1 \\ -1 \\ +1 \\ -2 \end{bmatrix}$

FIGURE 5

255 ⟵——— max ⎫
254                ⎬ range = 13 (4 bits)
248                ⎪
242 ⟵——— min ⎭
253
254
243

DECODE

ENCODE

WITH
QUANTIZATION
(with dithering)

(without dithering)

⎡ 7 ⎤
⎣ 242 ⎦

⎡ 13 ⎤
⎢ 12 ⎥
⎢ 6 ⎥    ⎫ 4-bit
⎢ 0 ⎥    ⎬ values
⎢ 11 ⎥   ⎭
⎢ 12 ⎥
⎣ 1 ⎦

"LOSSLESS"

→ DITHER →
" QUANTIZATION"

⎡ 7 ⎤
⎣ 242 ⎦

⎡ 7 ⎤
⎢ 6 ⎥
⎢ 3 ⎥    ⎫ 3-bit
⎢ 0 ⎥    ⎬ values
⎢ 5 ⎥    ⎭
⎢ 6 ⎥
⎣ 0 ⎦

"LOSSY"

FIGURE 6A

ORIGINAL
INPUT DATA
VALUES
↓

DECODED DATA
VALUES
↙

WORKINGS
↙

| ORIGINAL INPUT DATA VALUES | DECODED DATA VALUES | WORKINGS |
|---|---|---|
| 255 | 256 | $7 \rightarrow 14 + 242 = 256$ |
| 254 | 254 | $6 \rightarrow 12 + 242 = 254$ |
| 248 | 248 | $3 \rightarrow 6 + 242 = 248$ |
| 242 | 242 | $0 \rightarrow 0 + 242 = 242$ |
| 253 | 252 | $5 \rightarrow 10 + 242 = 252$ |
| 254 | 254 | $6 \rightarrow 12 + 242 = 254$ |
| 243 | 242 | $0 \rightarrow 0 + 242 = 242$ |

DECODE

$$\begin{bmatrix} 7 \\ 242 \end{bmatrix}$$

$$\begin{bmatrix} 7 \\ 6 \\ 3 \\ 0 \\ 5 \\ 6 \\ 0 \end{bmatrix}$$ } 3-bit values

( DITHERED
from 4-bit
values )

"LOSSY"

FIGURE 6B

LOOK AT A GROUP OF
INPUT DATA VALUES — S2

FIND MIN & MAX
VALUES — S4

FIND RANGE FROM
MIN → MAX
(MAX OFFSET) — S6

SET $x$ = NO. OF BITS TO ENCODE MAX OFFSET — S8

ENCODE OFFSETS
AS $x$-bit VALUES
(NO DITHERING) — S10

FIGURE 7

CONTROLLED
DATA RATE / COMPRESSION

```
┌─────────────────────────┐
│  LOOK AT A GROUP OF     │ ~ S2
│  INPUT DATA VALUES      │
└─────────────────────────┘
            │
            ▼
┌─────────────────────────┐
│  FIND  MIN & MAX        │ ~ S4
│       VALUES            │
└─────────────────────────┘
            │
            ▼
┌─────────────────────────┐
│  FIND  RANGE FROM       │ ~ S6
│      MIN → MAX          │
│     (MAX OFFSET)        │
└─────────────────────────┘
            │
            ▼
┌──────────────────────────────────────────────┐
│ SET  x = NO. OF BITS TO ENCODE MAX OFFSET     │ ~ S8
└──────────────────────────────────────────────┘
            │
            ▼        ~ S12
       ┌──────────────────┐
       │ COMPARE X TO Y   │
       └──────────────────┘
```

$x = Y$
OR
$X < Y$

$x > Y$

```
┌─────────────────────────┐        ┌─────────────────────────┐
│  ENCODE OFFSETS         │ ~ S14  │  ENCODE  OFFSETS        │ ~ S16
│  AS Y-BIT VALUES        │        │  AS  Y-BIT VALUES       │
│                         │        │                         │
│  ( NO DITHERING )       │        │  ( WITH DITHERING )     │
│    LOSSLESS             │        │     LOSSY               │
└─────────────────────────┘        └─────────────────────────┘
```

FIGURE 8

EP 2 819 412 A1

ACHIEVE DESIRED
COMPRESSION OR BETTER

LOOK AT A GROUP OF
INPUT DATA VALUES — S2

FIND MIN & MAX
VALUES — S4

FIND RANGE FROM
MIN → MAX
(MAX OFFSET) — S6

SET $x$ = NO. OF BITS TO ENCODE MAX OFFSET — S8

COMPARE X TO Y — S12

$x = Y$
OR
$x < Y$

$x > Y$

ENCODE OFFSETS
AS X-BIT VALUES
(NO DITHERING)
LOSSLESS — S18

ENCODE OFFSETS
AS Y-BIT VALUES
(WITH DITHERING)
LOSSY — S16

FIGURE 9

LOOK AT A GROUP OF INPUT DATA VALUES — S2

FIND MIN & MAX VALUES — S4

FIND RANGE FROM MIN → MAX (MAX OFFSET) — S6

SET $x$ = NO. OF BITS TO ENCODE MAX OFFSET — S8

COMPARE $x$ TO $y$ — S12

$x < y$

$x = y$

$x > y$ (WITH STORED CREDIT)

$x > y$ (NO STORED CREDIT)

ENCODE OFFSETS AS X-BIT VALUES (NO DITHER) LOSSLESS (CREDIT GAINED) — S20

ENCODE OFFSETS AS X-BIT VALUES (NO DITHER) LOSSLESS (NO CREDIT CHANGE) — S22

ENCODE OFFSETS AS X-BIT VALUES (NO DITHER) LOSSLESS (CREDIT CONSUMED) — S24

ENCODE OFFSETS AS Y-BIT VALUES (WITH DITHERING) LOSSY (NO CREDIT CHANGE) — S26

FIGURE 10

## EUROPEAN SEARCH REPORT

Application Number

EP 13 17 0946

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | "4.6.2 Differential Pulse-Code Modulation" In: Proakis J G; Salehi M: "Communication Systems Engineering", 1 January 1994 (1994-01-01), Prentice-Hall, XP002711742, ISBN: 0133006255 pages 264-267, * page 265, line 3 - page 266, line 10 * | 1,2,4,5, 12-14 | INV. H04N7/26 H04N7/34 H03M7/30 |
| X | "Chapter 7, Lossless Predictive Coding" In: Rabbani M; Jones P W: "Digital Image Compression Techniques", 1 February 1991 (1991-02-01), SPIE, XP002711743, ISBN: 0819406481 pages 58-67, * page 59, line 10 - page 62, paragraph 3 * | 1,2,4,5, 12-14 | |
| X | KONDO T ET AL: "ADAPTIVE DYNAMIC RANGE CODING SCHEME FOR FUTURE HDTV DIGITAL VTR", SIGNAL PROCESSING OF HDTV, 3. TURIN, SEPT. 4 - 6, 1991; [PROCEEDINGS OF THE INTERNATIONAL WORKSHOP ON HDTV AND BEYOND], AMSTERDAM, ELSEVIER, NL, vol. WORKSHOP 4, 4 September 1991 (1991-09-04), pages 43-50, XP000379937, * section 3 * | 1-3,5, 12-14 | TECHNICAL FIELDS SEARCHED (IPC) H04N H03M |

-/--

The present search report has been drawn up for all claims

| Place of search | Date of completion of the search | Examiner |
|---|---|---|
| Berlin | 29 November 2013 | Kontopodis, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 13 17 0946

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/170794 A1 (OGAWA MAYU [JP] ET AL) 14 July 2011 (2011-07-14) <br> * abstract * <br> * paragraph [0009] - paragraph [0011] * <br> * paragraph [0023] - paragraph [0025] * <br> * paragraph [0075] - paragraph [0111] * <br> * paragraph [0182] - paragraph [0185] * <br> * paragraph [0220] - paragraph [0228] * <br> * paragraph [0468] - paragraph [0518] * <br> * claim 1; figure 3 * | 1-15 | |
| X | BRAHIMI Z ET AL: "A lossless image compression algorithm using variable block size segmentation", IECON '98; PROCEEDINGS OF THE 24TH ANNUAL CONFERENCE OF THE IEEE INDUSTRIAL ELECTRONICS SOCIETY, AACHEN, GERMANY, 31 AUG.-4 SEPT. 1998, vol. 3, 31 August 1998 (1998-08-31), pages 1471-1476, XP010308311, DOI: 10.1109/IECON.1998.722868 ISBN: 978-0-7803-4503-4 <br> * abstract * <br> * section II.A * <br> * section III. * | 1-3,5,6, 12-15 | TECHNICAL FIELDS SEARCHED (IPC) |
| X | SOMOGYI T ET AL: "CODING OF PROGRESSIVELY SCANNED HDTV SIGNALS AT THE H4 DATA RATE (140 MBITS/SEC) OF THE DIGITAL HIERARCHY", SIGNAL PROCESSING OF HDTV, 2. TURIN, AUG. 30 - SEPT. 1, 1989; [PROCEEDINGS OF THE INTERNATIONAL WORKSHOP ON HDTV], AMSTERDAM, ELSEVIER, NL, 30 August 1989 (1989-08-30), - 1 September 1989 (1989-09-01), pages 813-820, XP000215300, <br> * section 2.1 * | 1-3,5-9, 15 | |

The present search report has been drawn up for all claims

| Place of search | Date of completion of the search | Examiner |
|---|---|---|
| Berlin | 29 November 2013 | Kontopodis, D |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

Europäisches
Patentamt

European
Patent Office

Office européen
des brevets

**Application Number**

EP 13 17 0946

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 13 17 0946

The Search Division considers that the present European patent application does not comply with the requirements of unity of invention and relates to several inventions or groups of inventions, namely:

```
1. claims: 1-4, 12-14(completely); 5(partially)

    Coding method using a bias value and offset values
                        ---

2. claims: 7-11, 15(completely); 6(partially)

    Coding method adapting the number of bits for the output
    data according to a performance target
                        ---

3. claims: 5, 6(partially)

    Coding method with adaptive selection of the number of input
    data values
                        ---
```

## ANNEX TO THE EUROPEAN SEARCH REPORT
## ON EUROPEAN PATENT APPLICATION NO.

EP 13 17 0946

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2013

| Patent document cited in search report | Publication date | Patent family member(s) | Publication date |
|---|---|---|---|
| US 2011170794 A1 | 14-07-2011 | CN 102165760 A<br>JP 5208218 B2<br>US 2011170794 A1<br>WO 2010035433 A1 | 24-08-2011<br>12-06-2013<br>14-07-2011<br>01-04-2010 |

EPO FORM P0459

For more details about this annex : see Official Journal of the European Patent Office, No. 12/82